Europäisches Patentamt

European Patent Office

Office européen des brevets

(11) Veröffentlichungsnummer: **0 262 332**
**A2**

## (12) EUROPÄISCHE PATENTANMELDUNG

(21) Anmeldenummer: 87111074.8

(22) Anmeldetag: 30.07.87

(51) Int. Cl.⁴: **H05K 9/00**

(30) Priorität: 01.08.86 DE 8620678 U
29.10.86 DE 8628884 U

(43) Veröffentlichungstag der Anmeldung:
06.04.88 Patentblatt 88/14

(84) Benannte Vertragsstaaten:
AT BE CH DE FR GB IT LI LU NL SE

(71) Anmelder: **Siemens Aktiengesellschaft Berlin
und München**
**Wittelsbacherplatz 2**
**D-8000 München 2(DE)**

(72) Erfinder: **Thomfohrde, Heiner**
**Flurstrasse 9**
**D-8021 Hohenschäftlarn(DE)**

(54) Leiterplatte für Nachrichtentechnik.

(57) Auf einer Leiterplatte (1) für die Nachrichtentechnik sind Einzelabschirmungen (3) für Bauteilegruppen vorgesehen, wobei auf der eventuell mit SMD-Bauteilen (9) zusätzlich bestückten Verdrahtungsseite (8) die Stifte (2) der Abschirmbecher (5) von der Bauteileseite her in größerer Anzahl und so hoch vorgesehen sind, daß auf sie ein Abschirmblech (3) aufsteckbar ist.

FIG 2

EP 0 262 332 A2

## Leiterplatte für die Nachrichtentechnik

Die Erfindung bezieht sich auf eine Leiterplatte für die Nachrichtentechnik mit steckbarer Abschirmung für darauf befindliche Bauelemente, die aus einem diese Bauteile umgebenden Blechrahmen besteht, der mit einem Steckdeckel versehen ist und auf der Schaltungsplatte mittels Lötstiften in Masseleiterbahnen verlötet ist.

Es besteht bei solchen Leiterplatten häufig die Anforderung, auch auf der anderen Seite der Leiterplatte mit Leiterbahnen und gegebenenfalls weiteren Bauelementen eine Abschirmung vorzusehen.

Der Erfindung liegt die Aufgabe zugrunde, auch hierfür eine einfache, praktikable Lösung anzugeben.

Bei einer Leiterplattenanordnung der eingangs genannten Art wird dies neuerungsgemäß dadurch erreicht, daß die Lötstifte auf der anderen Seite der Schaltungsplatte in größerer Anzahl und über die Leiterplattenebene sowie über darauf befindliche Bauelemente, wie sogenannte SMD, Bauteile, um einiges hinausragend ausgebildet sind und daß auf diese Stifte ein weiteres Abschirmblech aufgesteckt ist.

Nachstehend wird die Erfindung mitsamt ihren Vorteilen anhand des in den Figuren dargestellten Ausführungsbeispiels näher erläutert.

Die Figur 1 zeigt dabei eine Leiterplattenanordnung mit Einzelabschirmung von Bauelementen.

Die Figur 2 zeigt die Unterseite der Leiterplatte.

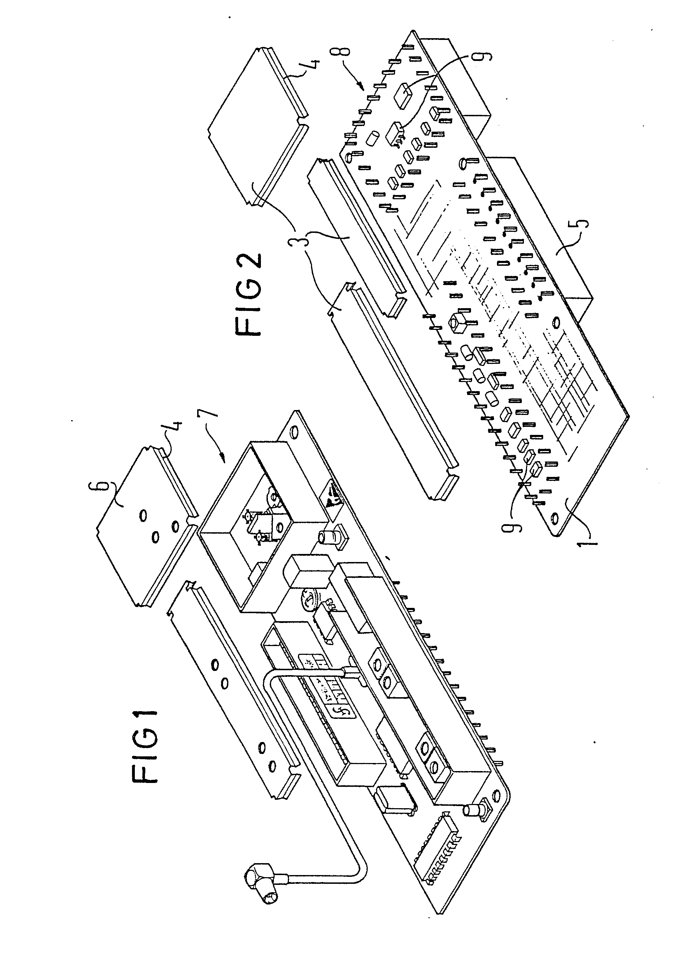

Insbesondere bei größeren Leiterplatten für die Nachrichtentechnik und Funktechnik sind Einzelabschirmungen für Bauelemente gemäß Figur 1 auf einer Seite der sogenannten Bauteileseite 7 vorgesehen. Dabei ist normalerweise ein Abschirmbecher als Rahmen ausgebildet und - mit Lötstiften versehen - auf der Leiterplatte verlötet. Um die Zugänglichkeit zu den Bauelementen zu erleichtern, sind steckbare Kappen 6 vorgesehen, die mit einem gesickten Rand 4 auf diese Rahmen 5 aufgesteckt sind.

Ist eine Abschirmung, wie bei solchen Baugruppen häufig gefordert, auch auf der Unterseite 8, normalerweise der sogenannten Leiterbahnseite erforderlich, so sind dort ebenfalls Abschirmbleche nötig. Besonders gilt dies, wenn, wie neuerdings häufig erforderlich, auch auf dieser Seite, auf der normalerweise die Schwallung vorgenommen wird, Bauelemente, zum Beispiel sogenannte SMD-Bauteile (Surface-monted-devices) vorhanden sind.

Um die Abschirmung zu befestigen, sind die Lötstifte 2 des Abschirmrahmens 5 an der Baugruppenoberseite in größerer Anzahl und in größerer Höhe als normalerweise erforderlich durch die Leiterplatte hindurchgesteckt und mit den Masseleiterbahnen verlötet. Durch die größere Anzahl und die Höhe der Stifte ist es möglich, nachträglich auf diese Stiftreihen Abschirmblechkappen 3 aufzustecken, die natürlich zur besseren Fixierung und Zentrierung ebenfalls mit gesickten Rändern 4 versehen sind. Wichtig ist dabei, daß die Stifthöhe und die Höhe dieser gesickten Ränder 4 so bemessen ist, daß zwischen den Massestiften hindurchgehende stromführende Leiterbahnen, die nicht isoliert sind und die Anschlüsse der SMD-Bauteile nicht berührt werden. Es ist auf diese Weise ohne zusätzli chen Aufwand möglich, Leiterbahnen auf der Verdrahtungsseite 8 der Baugruppe samt dort befindlichen Bauteilen mit leicht entfernbaren Abschirmkappen 3 gegen Ein- und Abstrahlung elektrischer Felder zu schützen.

## Ansprüche

1. Leiterplatte für die Nachrichtentechnik mit steckbarer Abschirmung für darauf befindliche Bauelemente, die aus einem diese Bauteile umgebenden Blechrahmen besteht, der mit einem Steckdeckel versehen ist und auf der Schaltungsplatte mittels Lötstiften in Masseleiterbahnen verlötet ist, **dadurch gekennzeichnet** , daß die Lötstifte (2) auf der anderen Seite der Schaltungsplatte (1) in größerer Anzahl und über die Leiterplattenebene sowie über darauf befindliche Bauelemente, wie sogenannte SMD-Bauteile (9), um einiges hinausragend ausgebildet sind und daß auf diese Stifte (2) ein weiteres Abschirmblech (3) aufgesteckt ist.

2. Leiterplatte nach Anspruch 1, **dadurch gekennzeichnet**, daß die Höhe der Stifte so bemessen ist, daß der gesickte Rand (4) des Abschirmbleches (3) die stromführenden Leiterbahnen der Leiterplatte (1) oder der etwa darauf befindlichen Bauteile (9) nicht berührt.

FIG 1

FIG 2